# EUROPÄISCHE PATENTSCHRIFT

(11) **EP 2 096 756 B1**
(45) Veröffentlichungstag und Bekanntmachung des Hinweises auf die Patenterteilung: **23.02.2011**
(21) Anmeldenummer: 09002483.7
(22) Anmeldetag: 21.02.2009
(51) Int. Cl.: H03K 17/08

(54) **Trennvorrichtung für einen Leistungshalbleiter und Verfahren zu deren Betreiben, Leistungsmodul und Systemanlage**
Separating device for a voltage semiconductor and method for operating same, power module and system assembly
Dispositif de séparation pour un semi-conducteur de puissance et son procédé de fonctionnement, module de puissance et installation du système

(30) Priorität: 28.02.2008 DE 102008011597
(43) Veröffentlichungstag der Anmeldung: 02.09.2009
(73) Patentinhaber: SEMIKRON Elektronik GmbH & Co. KG, 90431 Nürnberg (DE)
(72) Erfinder: Bittner, Roland, 96135 Stegaurach (DE); Jair, Do Nascimento, 91077 Dormitz (DE)

(56) Entgegenhaltungen:
- DE-A1- 19 600 807
- FR-A- 2 851 855
- GB-A- 1 204 650
- JP-A- 9 163 583
- JP-A- 2008 153 615
- US-A1- 2005 099 751

## Beschreibung

Elektrische Systemanlagen, in welchen hohe Spannungen bzw. Ströme geschaltet werden, sind heute mit sogenannten Leistungsmodulen ausgerüstet. Eine Systemanlage ist z.B. ein Windkraftgenerator. Ein Leistungsmodul enthält ein oder mehrere Leistungshalbleiter, z.B. in Form einer IGBT-Halbbrücke. Durch Zerstörung bzw. Ausfall eines einzigen Leistungsmoduls kann z.B. ein Kurzschluss oder Erdschluss vom Leistungsmodul zur Systemmasse erfolgen. Bei Ausfall eines entsprechenden Leistungsmoduls ist es heute bekannt, die Systemanlage auszuschalten und anschließend das zerstörte Leistungsmodul zu entfernen und zu ersetzen bzw. zu reparieren. Nach Einsetzen eines fehlerfreien Leistungsmoduls wird die Systemanlage wieder in Betrieb gesetzt. Ein derartiger Ausfall eines Leistungsmoduls führt also zu einer plötzlichen bzw. unerwarteten Unterbrechung oder Störung des Betriebs der Systemanlage und damit zu erheblichen Kosten.

Viele Systemanlagen weisen mehrere Leistungsmodule auf, die in der Regel.parallelisiert sind, um die gesamten Systemleistung zu erhöhen. Fällt bei z.B. massiver Parallelisierung ein einziges Leistungsmodul aus, würde die Systemleistung eigentlich nur geringfügig fallen. Trotz eventuell intakter paralleler bzw. redundanter Leistungsmodule kann jedoch z.B. bei einem Kurzschluss in einem einzigen defekten Modul ein Betrieb der Anlage nicht aufrecht erhalten werden. Die komplette Anlage muss wegen eines einzigen defekten Leistungsmoduls abgeschaltet werden.

Aufgabe der Erfindung ist es, eine verbesserte Vorrichtung und ein Verfahren anzugeben, um die oben genannten Nachteile zu beseitigen.

Hinsichtlich der Vorrichtung wird die Aufgabe gelöst durch eine Trennvorrichtung, welche als Vorschaltgerät für einen Leistungshalbleiter bzw. ein betreffendes Leistungsmodul dient und zusammen mit diesem betreibbar ist. Ein solcher Leistungshalbleiter weist eine Anzahl von n Leistungsanschlüssen auf, vermittels welcher er an ein Leistungsnetz anschließbar ist. Ist der Leistungshalbleiter z.B. eine Halbbrücke, weist dieser drei Anschlüsse, nämlich einen "+"- und einen "-"-Anschluss für einen Gleichspannungszwischenkreis und einen "AC"-Anschluss für eine Phase eines Wechselstromnetses auf.

Die Trennvorrichtung weist daher eine entsprechende Anzahl von n mit den Leistungsanschlüssen des Leistungshalbleiters verbindbaren Modulanschlüssen und n mit dem Leistungsnetz verbindbare Netzanschlüsse auf. Weiterhin weist die Trennvorrichtung n Verbindungsleitungen auf, von denen jede jeweils einen Netzanschluss mit jeweils einem Modulanschluss verbindet. Jede Verbindungsleitung enthält eine Überstromsicherung.

Die Trennvorrichtung enthält eine mit mindestens zwei, in der Regel jedoch allen, Überstromsicherungen verbundene Auslösesteuerung. Die Auslösesteuerung enthält einen Detektor zur Erkennung des Falls mindestens einer ersten der Sicherungen und eine Auslöseeinheit zur Auslösung mindestens einer zweiten der Überstromsicherungen.

Mit anderen Worten ist die Trennvorrichtung also n-polig zwischen ein Leistungsnetz und einen Leistungshalbleiter schaltbar. Jeder Pol ist dabei durch eine Überstromsicherung abgesichert, d.h. bei intakter Sicherung sind die entsprechenden Pole durchverbunden, bei ausgelöster bzw. gefallener Sicherung ist der jeweilige Leistungsanschluss des Leistungshalbleiters vom entsprechenden Pol des Leistungsnetzes getrennt. Der Detektor überwacht die Überstromsicherungen auf deren Ausfall. Die Auslöseeinheit dient zur gezielten Auslösung der Überstromsicherungen.

Die erfindungsgemäße Trennvorrichtung bietet den Vorteil, dass der Detektor einen Fall einer Sicherung bemerkt, der auf einen Fehler im Leistungshalbleiter hindeutet. Die Auslösesteuerung kann dann durch die Auslöseeinheit mindestens relevante Sicherungen auslösen, welche andere bzw. restliche fehlerhafte oder Probleme im angeschlossenen Leistungsnetz verursachende Leistungsanschlüsse des Leistungshalbleiters vom Leistungsnetz trennt. Das Leistungsnetz wird nach Auslösung der Sicherung fortan vom Leistungshalbleiter nicht mehr z.B. durch einen Kurzschluss oder Erdschluss belastet und kann weiter betrieben werden. Mit Hilfe der Trennvorrichtung kann also ein in der Regel zumindest eingeschränkter Betrieb des Leistungsnetzes aufrecht erhalten werden, auch wenn der Leistungshalbleiter ausfällt.

Durch die Erfindung ist es also möglich, Betriebsunterbrechung in einer Systemanlage zu vermeiden, Kosten zu sparen und einen vom Ausfall nicht beeinflussten weiteren Betreib der Systemanlage sicherzustellen. Besonders bei Energieerzeugungsanlagen wie Windgeneratoren ist dies ein erheblicher Vorteil.

In einer bevorzugten Ausgestaltung der Erfindung sind Detektor und/oder Auslöseeinheit jeweils allen Überstromsicherungen zugeordnet. Die Trennvorrichtung besitzt damit im ersten Fall vollständige Diagnosemöglichkeit und im zweiten Fall auch vollständige Steuerbarkeit für die Trennung beliebiger bzw. aller Leistungsanschlüsse des Leistungshalbleiters vom Leistungsnetz. Im Bedarfsfall kann so der gesamte Leistungshalbleiter komplett, also mit allen n Anschlüssen vom Leistungsnetz getrennt werden.

In einer weiteren bevorzugten Ausführungsform der Erfindung ist die Überstromsicherung eine Schmelzsicherung. Prinzipiell lässt sich die Trennvorrichtung auch mit Sicherungsautomaten aufbauen. Dies führt jedoch insbesondere bei massiv parallelen Systemanlagen, wie z.B. einer Windkraftanlage mit zig parallelen Leistungsmodulen zu erheblichen Kosten. Eine Schmelzsicherung hingegen ist kostengünstig, weshalb die gesamte Trennvorrichtung kostengünstig wird.

Im Falle eines Sicherungsautomaten wäre eine Auslöseeinheit denkbar, die einen Auslösemechanismus an der Sicherung betätigt. Insbesondere in Verbindung mit Schmelzsicherung ist in einer weiteren bevorzugten Ausführungsform die Auslöseeinheit jedoch so ausgestaltet, dass sie zur Auslösung einer Überstromsicherung diese gezielt mit einem der Sicherung im Leistungs- bzw. Sicherungspfad zugeführten Überstrom beaufschlagt. Durch die Auslöseeinheit wird also der Sicherung auf ihrem tatsächlichen Leistungspfad ein zu deren Auslösung führender Überstrom bewusst zugeführt. Auch ein derartiger Überstrom ist einfach und kostengünstig durch eine Auslöseeinheit erzeugbar und senkt somit die Kosten der Trennvorrichtung. Bei der Dimensionierung der Auslöseeinheit ist wichtig, dass der minimal von der Auslösevorrichtung erzeugbare Faktor i²t größer ist als der maximal zulässige Faktor i²t der zu zerstörenden Sicherung.

Zum Zweck der Zuführung von Überstrom weist in einer vorteilhaften Ausgestaltung die Auslöseeinheit eine Auslöseleitung auf, welche an den Strompfad, also direkt an die Überstromsicherung, angeschlossen ist. Die Auslöseleitung ist in Ruhe hochohmig und zur Auslösung niederohmig schaltbar, wobei die Auslöseleitung die Überstromsicherung mit einer Spannungsquelle verbindet. Mit anderen Worten wird bei einer derartigen Trennvorrichtung eine geschaltete Verbindung zu einer Spannungsquelle hergestellt, welche im Bedarfsfall geschlossen wird, um von der Spannungsquelle einen geeigneten Auslösestrom durch die Überstromsicherung zu schicken. Eine Spannungsquelle steht hierbei stellvertretend natürlich auch für eine Stromquelle.

In einer besonders bevorzugten Ausführungsform ist die Spannungsquelle das dem Leistungshalbleiter zugeordnete Leistungsnetz. Das Leistungsnetz selbst wird damit zur Auslösung der Überstromsicherungen benutzt, was die Bereitstellung einer zusätzlichen Spannungsquelle überflüssig macht. In der Regel ist jedes Leistungsnetz, an welches ein Leistungshalbleiter angeschlossen ist, zur Auslösung einer entsprechenden Sicherung, nämlich zur Erzeugung eines unerlaubt hohen Auslösestromes fähig.

In einer weiteren bevorzugten Ausführungsform führt die genannte Auslöseleitung von einem Modulanschluss der Trennvorrichtung zu einem nicht diesem zugeordneten Netzanschluss. Ein nicht zugeordneter Netzanschluss ist hierbei ein solcher, welcher also nicht parallel zur Leitungsführung der dem Modulanschluss zugehörenden Verbindungsleitung führt. Durch eine entsprechende Auslöseleitung wird mit anderen Worten eine Kreuzverbindung zwischen verschiedenen Polen des Leistungshalbleiters bzw. Leistungsnetzes hergestellt, welche in der Regel ausreichende Spannungen aufweisen, um in der Auslöseleitung im Bedarfsfall ausreichend hohe Auslöseströme zu erzeugen.

Die Schaltbarkeit der Auslöseleitung wird in einer weiteren vorteilhaften Ausführungsform dadurch erreicht, dass die Auslöseleitung einen zur Auslösung durchschaltbaren Thyristor und eine diesem zugeordnete Zündeinheit enthält. Insbesondere in Verbindung mit einer Schmelzsicherung eignet sich ein Thyristor besonders gut zur Stromerzeugung, da dieser im Ruhezustand in beide Stromrichtungen sperrt und bezüglich seiner Stromcharakteristik gut zu einer Schmelzsicherungen passt, hierbei wenig Chipfläche beansprucht und in der Regel besonders robust ist. Das Funktionieren des Thyristors ist somit zum Auslösen der Sicherung sichergestellt.

Die Trennvorrichtung weist in einer weiteren vorteilhaften Ausführungsform einen Signaleingang zur gezielten Auslösung mindestens einer der Überstromsicherungen auf. So kann durch ein extern am Signaleingang angelegtes Signal gezielt ein Leistungshalbleiter ein-, mehr- oder vollpolig vom Leistungsnetz getrennt werden. Dies kann z.B. gewünscht sein, wenn der Leistungshalbleiter seine geschätzte Lebensdauer erreicht hat und sicherheitshalber während des Betriebs der Systemanlage deaktiviert, also von dieser getrennt werden soll, bevor er unkontrolliert ausfällt und dabei einen Kurzschluss o.ä. verursacht. Ein derartiger Signaleingang kann z.B. an einer übergeordneten Steuerung oder Leitwarte angeschlossen sein, die die Systemanlage überwacht bzw. steuert.

Die Trennvorrichtung weist in einer weiteren vorteilhaften Ausführungsform auch einen mit dem Fall mindestens einer der Überstromsicherungen korrelierten Signalausgang, z.B. zur Fehlerrückmeldung, auf. Somit steht ein Signal zur Verfügung, welches über den Ausfall mindestens einer oder auch aller Sicherungen informiert und z.B. in der übergeordneten Steuerung weiterverarbeitet werden kann. So kann z.B. der Ausfall eines Leistungsmoduls erkannt bzw. auch lokalisiert werden. Ein entsprechendes Leistungsmodul kann somit z.B. für eine Wartung identifiziert werden. Diagnoserückmelde- und Eingriffsmöglichkeiten lassen sich hierbei noch durch Messwerterfassung im Auslösemoment, Positionsangaben der Fehlermeldungen etc. ergänzen.

Die Aufgabe der Erfindung wird auch gelöst durch ein Leistungsmodul, welches einen Leistungshalbleiter und eine diesem zugeordnete oben beschriebene Trennvorrichtung umfasst. Die Schnittstelle zum Leistungsnetz sind weiterhin die Leistungsanschlüsse der Trennvorrichtung, in welche dann der Leistungshalbleiter integriert ist.

Die Aufgabe der Erfindung wird auch gelöst durch eine Systemanlage, die mindestens zwei an ihren Netzanschlüssen der Trennvorrichtungen parallelisierte Leistungsmodule, wie eben beschrieben, enthält. Eine derartige Systemanlage gemäß der Erfindung besteht in der Regel sogar aus einer Vielzahl parallelisierter Leistungsmodule, die je nach Anwendung unterschiedlich verschaltet sind, jedes der Leistungsmodule besitzt dabei eine wie oben erläuterte Trennvorrichtung zur gezielten Auslösung der Sicherungen und damit Trennung eines einzelnen Leistungsmoduls aus der Systemanlage.

Für die Auslegung einer erfindungsgemäßen Systemanlage existieren damit zwei - auch kombinierbare - Richtlinien:

Entweder kann eine ausreichende Redundanz an Leistungsmodulen geschaffen werden, d.h. die Leistungsmodule in Summe weisen eine die Nenn-Systemleistung übersteigende Leistung auf. So kann die Systemanlage auch nach Zerstörung eines oder weniger der Leistungsmodule mit voller Nennleistung weiterbetrieben werden.

Eine zweite Möglichkeit ist, keine redundanten Leistungsmodule vorzusehen, und die Systemleistung bei Ausfall in dem Maße zu reduzieren, die der Leistungseinbuße der Anzahl zerstörter Leistungsmodule entspricht.

Eine derartige Systemanlage muss damit nicht plötzlich angehalten werden, um im Fehlerfall mit einer Korrektivwartung zu arbeiten, sondern es kann zu einem späteren Zeitpunkt, wenn ein Anlagenstillstand tolerierbar oder günstig ist, eine präventive Wartung durchgeführt werden, d.h. ein zerstörtes bzw. aus dem System durch die Trennvorrichtung getrenntes Leistungsmodul ausgetauscht werden.

Hinsichtlich des Verfahrens wird die Aufgabe gelöst durch ein Verfahren zum Betreiben einer wie oben beschriebenen Trennvorrichtung, bei dem bei Erfüllung eines Auslösekriteriums mindestens eine der Überstromsicherungen ausgelöst wird. Insbesondere können natürlich, wie oben mehrfach beschrieben, auch sämtliche Überstromsicherungen im Falle des Auslösekriteriums ausgelöst werden.

Das Auslösekriterium ist, wie ebenfalls beschrieben, z.B. ein gezielt aufgebrachtes Signal am Signaleingang, z.B. bei Überschreitung der Lebenserwartung eines Leistungsmoduls, oder auch, wie oben beschrieben, in einer bevorzugten Ausführungsform des Verfahrens der Fall mindestens einer der vom Detektor überwachten Sicherungen in der Trennvorrichtung.

Das erfindungsgemäße Verfahren wurde bereits zusammen mit der erfindungsgemäßen Trennvorrichtung, auch hinsichtlich seiner Vorteile, beschrieben.

Für eine weitere Beschreibung der Erfindung wird auf die Ausführungsbeispiele der Zeichnungen verwiesen. Es zeigen, jeweils in einer schematischen Prinzipskizze:
- Fig. 1: ein Leistungsmodul mit Trennvorrichtung und Leistungshalbleiter an einem Leistungsnetz,
- Fig. 2: eine Systemanlage mit K Leistungsmodulen gemäß Fig. 1.

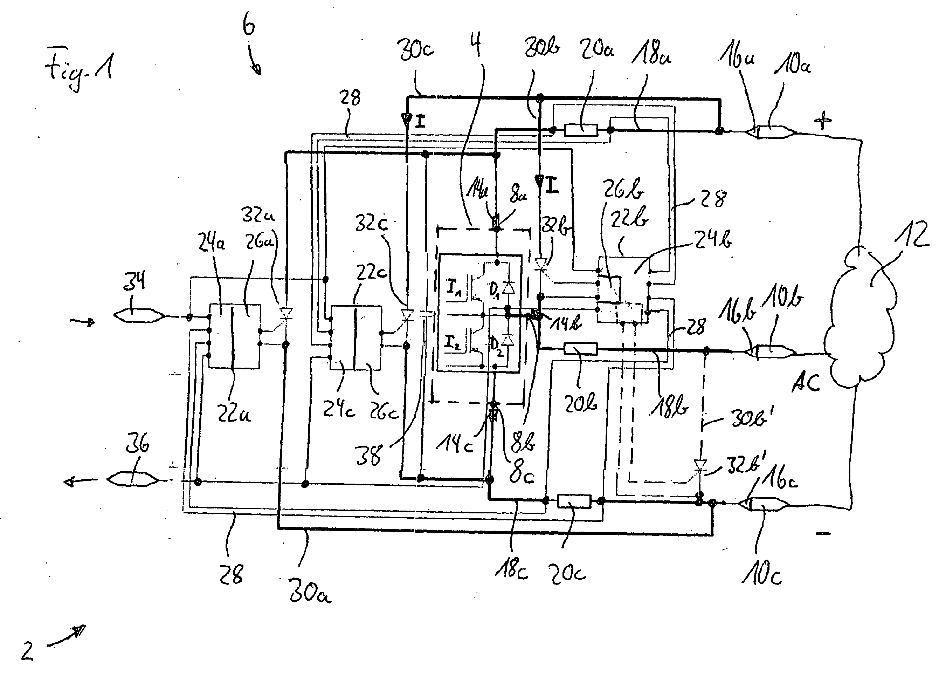

Fig. 1 zeigt ein Leistungsmodul 2, welches als Leistungshalbleiter eine Halbbrücke 4 mit zwei IGBTS 11 und 12 und Dioden D1 und D2 enthält. Das Leistungsmodul 2 umfasst auch eine die Halbbrücke 4 umgebende Trennvorrichtung 6, zu welcher also die Halbbrücke 4 nicht zählt. Die Halbbrücke 4 besitzt n=3 Leistungsanschlüsse 8a-c, welche zum Anschluss an drei Pole 10a-c eines Leistungsnetzes 12 dienen. Die Pole 10a und 10c sind Pole "+" und "-" eines nicht dargestellten Gleichstromzwischenkreises; Pol 10b ist eine Phase AC eines nicht dargestellten Wechselstromnetzes.

In Fig. 1 ist erfindungsgemäß zwischen Leistungsnetz 12 bzw. dessen Pole 10a-c und die Leistungsanschlüsse 8a-c der Halbbrücke 4 die erfindungsgemäße Trennvorrichtung 6 geschaltet.

Die Trennvorrichtung 6 weist hierzu einerseits drei Modulanschlüsse 14a-c für die Leistungsanschlüsse 8a-c und andererseits drei Netzanschlüsse 16a-c für die Pole 10a-c auf. Jeder Modulanschluss 14a-c ist mit jedem Netzanschluss 16a-c durch jeweils eine Verbindungsleitung 18a-c verbunden, welche wiederum jeweils eine Sicherung 20a-c in Form einer Schmelzsicherung beinhaltet.

Die Trennvorrichtung 6 enthält außerdem eine dreiteilige Auslösesteuerung in Form der Auslösemodule 22a-c, welche jeweils zweigeteilt in einen Detektor 24a-c und eine Zündeinheit 26a-c sind.

Die Detektoren 24a,c sind hierbei über Messleitungen 28 mit der Sicherung 20a,c verbunden, der Detektor 24c mit beiden Sicherungen 20a,c. Über die Messleitungen überwacht jeder Detektor 24a-c den jeweiligen Spannungsabfall über der entsprechenden Sicherung 20a,c. In einer nicht dargestellten Alternativen Ausführungsform ist auch die Sicherung 20b über eine Messleitung 28 durch die Detektoren 24a-c überwacht.

Jede Zündeinheit 26a-c wiederum ist mit jeweils einem Thyristor 32a-c verbunden, der in einer jeweiligen Auslöseleitung 30a-c enthalten ist. Die Auslöseleitungen 32a-c überbrücken jeweils die Halbbrücke 4, wie in Fig. 1 zu sehen ist, so dass bei Durchverbindung der jeweiligen Auslöseleitung jeweils eine Sicherung 20a-c in einem zwischen Polen 10a-c verlaufenden Stromweg liegt.

Jeder Detektor 24a-c verfügt zusätzlich über einen auf einen Auslöseeingang 34 und auf einen Fehlerausgang 36 geführten Ein- und Ausgang.

Fig. 1 zeigt einen Kondensator 38, welcher die parasitären Induktivitäten der Sicherungen 20a-c gegenüber der Halbbrücke 4 kompensiert. D.h. der Kondensator 38 ist ein sogenannter Snubber-Kondensator, der dazu dient, die Überspannungen bei der Kommutierung der IGBTs I₁ und I₂ zu unterdrücken.

Bei Halbleiterleistungsmodulen wie der Halbbrücke 4 bilden sich in den meisten Zerstörungsfällen Durchlegierung zwischen verschiedenen Schichten der Halbleiter, d.h. es entstehen Kurzschlüsse zwischen den Leistungsanschlüssen 8a-c und einer nicht dargestellten Systemmasse. Dies kann zu sehr hohen Kurzschlussströmen an den Polen 10a-c des Leistungsnetzes 12 führen. Bei einem derartigen Fehlerfall brennt mindestens eine der Sicherungen 20a-c durch.

Im Folgenden wird beschrieben, dass durch einen Fehler in der Halbbrücke 4 die Sicherung 20a durchbrennt. Es ist jedoch auch denkbar, dass eine andere der Sicherungen zuerst durchbrennt.

Das Auslösemodul 22c detektiert im Detektor 24c über die Messleitung 28 einen Spannungsabfall an der Sicherung 20a und aktiviert die Zündeinheit 26a, d.h. den Thyristor 32c. Über die Auslöseleitung 30c fließt vom Pol 10a ein Überstrom I durch die Sicherung 20c zum Pol 10c, was zur Zerstörung der Sicherung 20c führt. In einem derartigen Fall sollte die Sicherung 20b bereits durch den Fehler in der Halbbrücke 4 ebenfalls ausgelöst sein. Für den Fall, dass dies jedoch nicht geschehen ist, detektiert der Detektor 24b das Durchbrennen der Sicherungen 20a,c und aktiviert über die Zündeinheit 26b den Thyristor 32b, weshalb über die Auslöseleitung 30b der Überstrom I vom Pol 10a zum Pol 10b fließt und die Sicherung 20b fällt. Dies gilt auch für den Fall, dass z.B. der Pol 10 einer Gleich- und der Pol 10b einer Wechselspannung unterworfen ist, wenn die erste Periode der Wechselspannung durchlaufen ist.

Da nun alle drei Sicherungen 20a-c zerstört sind, ist die Halbbrücke 4 vollständig vom Leistungsnetz 12 isoliert, welches fehlerfrei weiterbetrieben werden kann.

Fig. 1 zeigt gestrichelt eine alternative Ausführungsform einer Trennvorrichtung 6, welche zusätzlich zur Auslöseleitung 30b eine weitere Auslöseleitung 30b' mit Thyristor 32b' enthält, welcher ebenfalls über die Zündeinheit 26b angesteuert ist. Zum kontrollierten Durchbrennen der Sicherung 20b ergibt sich so über die Auslöseleitungen 30b und 30b' auch ein Auslösepfad zwischen den Polen 10a und 10c des Leistungsnetzes 12.

Die jeweilige Detektion einer zerstörten Sicherung 20a-c über die Messleitungen 18 wird vom jeweiligen Detektor 24a-c in Form eines Fehlersignals am Fehlerausgang 36 ausgegeben. Von dort kann das Signal z.B. an eine nicht dargestellte übergeordnete Steuerung oder Leitwarte weitergeleitet und weiterverarbeitet werden, die so über das zerstörte Leistungsmodul 2 informiert ist. Über ein von einer derartigen Steuerung eingespeistes Signal am Auslöseeingang 34 sind außerdem sämtliche Auslösemodule 22a-c auch ohne vorherigen Fall einer Sicherung 20a-c aktivierbar, um alle drei Sicherungen 20a-c gezielt zu zerstören.

Das jeweilige Auslösemodul 22a-c weist in der Regel eine Potentialtrennung auf, welche zwischen den Anschlüssen für die Messleitungen 28 und für die Thyristoren 32a-c bzw. den Anschlüssen für Auslöseeingang 34 und Fehlerausgang 36 liegt.

Die Thyristoren 32a-c werden nur für die zur sicheren Auslösung der Sicherungen 20a-c benötigte Zeit gezündet. Da die Thyristoren stets eine Verbindung zur nicht dargestellten Systemanlage aufweisen, in welcher das Leistungsmodul 2 integriert ist, könnte sonst ein eventuell in der zerstörten Halbbrücke 4 vorhandener Kriechweg geschlossen werden, der dann zu einem Kriechstrom führen und die Störsicherheit der gesamten Systemanlage beinträchtigen würde.

Für den Fall, dass die Sicherung 20b zuerst durchbrennt, wird dies zunächst nicht bemerkt, da diese Sicherung 20b gemäß Fig. 1 nicht überwacht ist. Bei einem derartigen Fehler brennt jedoch immer auch eine der Sicherungen 20a,c durch, da der Fehler in der Halbbrücke 4 auch zu einem Kurzschluss bezüglich der Pole "+" oder "-" führt. Der Fall einer der Sicherungen 20a,c wird dann detektiert und wie oben beschrieben fortgefahren.

Die Halbbrücke 4 in Fig. 1 ist lediglich als Beispiel zu verstehen. Diese kann auch durch eine beliebige Leistungshalbleiterschaltung ersetzt sein, woraufhin die Topologie der Trennvorrichtung 6 entsprechend anzupassen wäre.

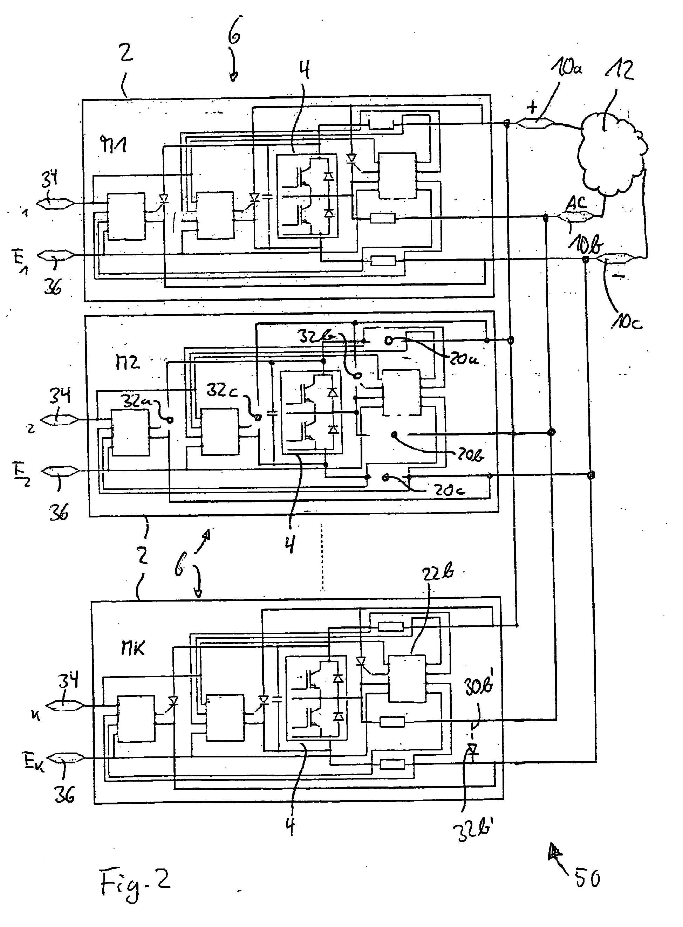

Fig. 2 zeigt eine Systemanlage 50, welche eine Anzahl von K Leistungsmodulen 2, mit M₁ bis M_{K} bezeichnet, umfasst. Sämtliche Module M₁ bis M_{K} sind an ihren Polen 10a-c parallel geschaltet. Die Auslöseeingänge 34 und Fehlerausgänge 36 sind für jedes Modul M₁ bis M_{K} individuell als Eingänge A₁ bis A_{K} und Ausgänge E₁ bis E_{K} gekennzeichnet und separat zu der übergeordneten Steuerung geführt. So kann jedes einzelne Modul M₁ bis M_{K} separat ausgelöst bzw. vom Leistungsnetz 12 getrennt oder ein Fehler in diesem diagnostiziert und damit auch lokalisiert werden.

Im Beispiel von Fig. 2 ist verdeutlicht, wie im Modul M₂ die Halbbrücke 4 vollständig vom Netz getrennt ist. Die Sicherungen 20a-c sind durchgebrannt und zur Verdeutlichung nicht mehr dargestellt. Die Thyristoren 32a-c sind nach erfolgter Trennung des Moduls M₂ wieder ausgeschaltet und stellen damit einen elektrischen Leerlauf dar; in Fig. 2 ebenfalls durch deren Weglassung verdeutlicht.

In Fig. 2 ist damit zu erkennen, wie im Modul M₂ sämtliche vom Leistungsnetz 12 herführenden Leistungsleitungen an einem offenen Ende enden. Die restlichen K-1 Leistungsmodule 2 in der Systemanlage 50 arbeiten daher wie gewohnt weiter.

Die in Fig. 1 gestrichelt gezeigte Lösung mit dem zusätzlichen Thyristor 32b' bzw. Auslöseleitung 30b' ist in Fig. 2 nur im Modul M_{K} dargestellt. Für eine derartige Systemverschaltung ist zu erkennen, dass ein Schließen des Thyristors 32b' sämtliche Anschlüsse der Phasen "AC" aller anderen K-1 Leistungsmodule 2 auf den Pol "-" ziehen würde und damit die gesamte Systemanlage 50 beansprucht wäre. Für leitende IGBTs I₂ in anderen Leistungsmodulen 2 würde hier die jeweilige Sicherungen 20b durchbrennen, da über diese Sicherung und das Modul M bzw. den Thyristor 32b' ein Kurzschlussstrompfad entsteht. Im Leistungsmodul M_{K} ist daher im Auslösemodul 22b eine Funktion integriert, welche die Spannungen zwischen der Phase "AC" und dem Pol "-" überwacht und den Thyristor 32b' nur dann zündet, wenn die Spannung zwischen Phase "AC" und Pol "-" unter einer definierten Schwelle liegt. Somit wird kein vom Normalbetrieb abweichender Zustand an der Phase "AC" erzeugt und die Leistungsmodule M₁ bis M_{K-1} nicht belastet.

## Patentansprüche

1. Trennvorrichtung (6) für einen Leistungshalbleiter (4) mit n Leistungsanschlüssen (8a-c) für ein Leistungsnetz (12), mit
- n, mit den Leistungsanschlüssen (8a-c) verbindbaren Modulanschlüssen (14a-c),
- n, mit dem Leistungsnetz (12) verbindbaren Netzanschlüssen (16a-c),
- n, je einen Modulanschluss (14a-c) mit je einem Netzanschluss (16a-c) verbindenden, eine Überstromsicherung (20a-c) enthaltenden Verbindungsleitungen (18a-c),
- einer mit den Überstromsicherungen (20a-c) verbundenen Auslösesteuerung (22a-c), enthaltend,
- einen Detektor (24a-c,28) zur Erkennung des Falls mindestens einer ersten der Überstromsicherungen (20a-c),
- einer Auslöseeinheit (26a-c,30a-c,32a-c) zur Auslösung mindestens einer zweiten der Überstromsicherungen (20a-c).

2. Trennvorrichtung (6) nach Anspruch 1, bei der der Detektor (24a-c,28) und/oder die Auslöseinheit (26a-c,30a-c,32a-c) jeweils allen Überstromsicherungen (20a-c) zugeordnet sind.

3. Trennvorrichtung (6) nach Anspruch 1 oder 2, bei der die Überstromsicherung (20a-c) eine Schmelzsicherung ist.

4. Trennvorrichtung (6) nach einem der vorhergehenden Ansprüche, bei der die Auslöseeinheit (26a-c,30a-c,32a-c) eine solche zur Auslösung der Überstromsicherung (20a-c) durch Beaufschlagung mit einem gezielt zugeführten Überstrom (I) ist.

5. Trennvorrichtung (6) nach Anspruch 4, bei der die Auslöseeinheit (26a-c,30a-c,32a-c) eine an die Überstromsicherung (20a-c) angeschlossene, in Ruhe hochohmige und zur Auslösung niederohmig schaltbare, mit einer Spannungsquelle (12) verbindbare Auslöseleitung (30a-c) aufweist.

6. Trennvorrichtung (6) nach Anspruch 5, bei der die Spannungsquelle (12) das dem Leistungshalbleiter zugeordnete Leistungsnetz (12) ist.

7. Trennvorrichtung nach Anspruch 5 oder 6, bei der die Auslöseleitung (30a-c) von einem Modulanschluss (14a-c) zu einem diesem nicht zugeordneten Netzanschluss (16a-c) führt.

8. Trennvorrichtung (6) nach einem der Ansprüche 5 bis 7, bei der die Auslöseleitung (30a-c) einen zur Auslösung durchschaltbaren Thyristor (32a-c) und eine diesem zugeordnete Zündeinheit (26a-c) enthält.

9. Trennvorrichtung (6) nach einem der vorhergehenden Ansprüche, mit einem Signaleingang (34) zur gezielten Auslösung mindestens einer der Überstromsicherungen (20a-c).

10. Trennvorrichtung (6) nach einem der vorhergehenden Ansprüche, mit einem mit dem Fall mindestens einer der Überstromsicherungen (20a-c) korrelierten Signalausgang (36).

11. Leistungsmodul (2) mit einem Leistungshalbleiter (4) und einer Trennvorrichtung (6) nach einem der Ansprüche 1 bis 10.

12. Systemanlage (50) mit mindestens zwei, an ihren Netzanschlüssen (16a-c) parallel geschalteten Leistungsmodulen (2) nach Anspruch 11.

13. Verfahren zum Betreiben einer Trennvorrichtung (6) nach einem der Ansprüche 1 bis 10, bei dem bei Erfüllung eines Auslösekriteriums mindestens eine der Überstromsicherungen (20a-c) ausgelöst wird.

14. Verfahren nach Anspruch 13, bei dem das Auslösekriterium der Fall mindestens einer der Sicherungen (20a-c) ist.

## Claims

1. Disconnecting device (6) for a power semiconductor (4) with n power connections (8a-c) for a power network (12), with
- n module connections (14a-c) which can be connected to the power connections (8a-c),
- n network connections (16a-c) which can be connected to the power network (12),
- n connection lines (18a-c) connecting each module connection (14a-c) to each network connection (16a-c) and containing an overcurrent cut-out (20a-c),
- a trigger control (22a-c) connected to the overcurrent cut-outs (20a-c), containing,
- a detector (24a-c, 28) for detecting the fall of at least a first of the overcurrent cut-outs (20a-c),
- a trigger unit (26a-c, 30a-c, 32a-c) for triggering at least a second of the overcurrent cut-outs (20a-c).

2. Disconnecting device (6) according to Claim 1, in which the detector (24a-c, 28) and/or the trigger unit (26a-c, 30a-c, 32a-c) are assigned to all overcurrent cut-outs (20a-c) in each case.

3. Disconnecting device (6) according to Claim 1 or 2, in which the overcurrent cut-out (20a-c) is a fusible cut-out.

4. Disconnecting device (6) according to any one of the preceding claims, in which the trigger unit (26a-c, 30a-c, 32a-c) is one for triggering the overcurrent cut-out (20a-c) by means of loading with a targetedly supplied overcurrent (I).

5. Disconnecting device (6) according to Claim 4, in which the trigger unit (26a-c, 30a-c, 32a-c) has a trigger line (30a-c) connected to the overcurrent cut-out (20a-c), of high resistance at rest and switchable to low resistance for triggering and connectible to a voltage source (12).

6. Disconnecting device (6) according to Claim 5, in which the voltage source (12) is the power network (12) assigned to the power semiconductor.

7. Disconnecting device according to Claim 5 or 6, in which the trigger line (30a-c) leads from a module connection (14a-c) to a network connection (16a-c) not assigned to the same.

8. Disconnecting device (6) according to any one of Claims 5 to 7, in which the trigger line (30a-c) contains a thyristor (32a-c) which can be wired through for triggering and an ignition unit (26a-c) assigned to the same.

9. Disconnecting device (6) according to any one of the preceding claims, with a signal input (34) for the targeted triggering of at least one of the overcurrent cut-outs (20a-c).

10. Disconnecting device (6) according to any one of the preceding claims, with a signal output (36) correlated with the fall of at least one of the overcurrent cut-outs (20a-c).

11. Power module (2) with a power semiconductor (4) and a disconnecting device (6) according to any one of Claims 1 to 10.

12. System installation (50) with at least two power modules (2) according to Claim 11 connected in parallel at their network connections.

13. Method for operating a disconnecting device (6) according to any one of Claims 1 to 10, in which in the case of the fulfilment of a trigger criterion, at least one of the overcurrent cut-outs (20a-c) is triggered.

14. Method according to Claim 13, in which the trigger criterion is the fall of at least one of the cut-outs (20a-c).

## Revendications

1. Dispositif de séparation (6) pour un semi-conducteur de puissance (4) comprenant n branchements de puissance (8a-c) pour un réseau de puissance (12), comprenant
- n branchements de module (14a-c) pouvant être reliés aux branchements de puissance (8a-c),
- n branchements de réseau (16a-c) pouvant être reliés au réseau de puissance (12),
- n lignes de liaison (18a-c) reliant chacune un branchement de module (14a-c) à respectivement un branchement de réseau (16a-c) et contenant un fusible de sûreté (20a-c),
- une commande de déclenchement (22a-c) reliée aux fusibles de sûreté (20a-c), contenant
- un détecteur (24a-c, 28) pour la détection de la chute d'au moins un premier des fusibles de sûreté (20a-c),
- une unité de déclenchement (26a-c, 30a-c, 32a-c) pour le déclenchement d'au moins un second des fusibles de sûreté (20a-c).

2. Dispositif de séparation (6) selon la revendication 1, sur lequel le détecteur (24a-c, 28) et/ou l'unité de déclenchement (26a-c, 30a-c, 32a-c) sont attribués respectivement à tous les fusibles de sûreté (20a-c).

3. Dispositif de séparation (6) selon la revendication 1 ou 2, sur lequel le fusible de sûreté (20a-c) est une pièce fusible.

4. Dispositif de séparation (6) selon l'une quelconque des revendications précédentes, sur lequel l'unité de déclenchement (26a-c, 30a-s, 32a-c) est une unité pour le déclenchement du fusible de sûreté (20a-c) par alimentation avec une surintensité de courant (I) amenée de façon ciblée.

5. Dispositif de séparation (6) selon la revendication 4, sur lequel l'unité de déclenchement (26a-c, 30a-c, 32a-c) présente une ligne de déclenchement (30a-c) raccordée au fusible de sûreté (20a-c), commutable avec une impédance élevée au repos et une faible impédance pour le déclenchement, pouvant être reliée à une source de tension (12).

6. Dispositif de séparation (6) selon la revendication 5, sur lequel la source de tension (12) est le réseau de puissance (12) attribué au semi-conducteur de puissance.

7. Dispositif de séparation selon la revendication 5 ou 6, sur lequel la ligne de déclenchement (30a-c) va d'un branchement de module (14a-c) à un branchement de réseau (16a-c) non attribué à celui-ci.

8. Dispositif de séparation (6) selon l'une quelconque des revendications 5 à 7, sur lequel la ligne de déclenchement (30a-c) contient un thyristor (32a-c) commutable pour le déclenchement et une unité d'allumage (26a-c) attribuée à celui-ci.

9. Dispositif de séparation (6) selon l'une quelconque des revendications précédentes, comprenant une entrée de signal (34) pour le déclenchement ciblé d'au moins l'un des fusibles de sûreté (20a-c).

10. Dispositif de séparation (6) selon l'une quelconque des revendications précédentes, comprenant une sortie de signal (36) corrélée avec la chute d'au moins l'un des fusibles de sûreté (20a-c).

11. Module de puissance (2) comprenant un semi-conducteur de puissance (4) et un dispositif de séparation (6) selon l'une quelconque des revendications 1 à 10.

12. Installation de système (50) comprenant au moins deux modules de puissance (2), raccordés en parallèle à leurs branchements de réseau (16a-c), selon la revendication 11.

13. Procédé pour faire fonctionner un dispositif de séparation (6) selon l'une quelconque des revendications 1 à 10, dans lequel au moins l'un des fusibles de sûreté (20a-c) est déclenché lorsqu'un critère de déclenchement est satisfait.

14. Procédé selon la revendication 13, dans lequel le critère de déclenchement est la chute d'au moins l'un des fusibles (20a-c).
